# EUROPÄISCHE PATENTSCHRIFT

(11) **EP 1 463 845 B1**
(45) Veröffentlichungstag und Bekanntmachung des Hinweises auf die Patenterteilung: **08.02.2012**
(21) Anmeldenummer: 02792675.7
(22) Anmeldetag: 18.12.2002
(51) Int. Cl.: C23C 4/10, F16L 59/00

(54) **HERSTELLUNG EINES KERAMISCHEN WERKSTOFFES FÜR EINE WÄRMEDÄMMSCHICHT SOWIE EINE DEN WERKSTOFF ENTHALTENDE WÄRMEDÄMMSCHICHT**
PRODUCTION OF A CERAMIC MATERIAL FOR A HEAT-INSULATING LAYER AND HEAT-INSULATING LAYER CONTAINING SAID MATERIAL
PRODUCTION D'UN MATERIAU CERAMIQUE POUR UNE COUCHE CALORIFUGE ET COUCHE CALORIFUGE CORRESPONDANTE CONTENANT LEDIT MATERIAU

(30) Priorität: 11.01.2002 DE 10200803
(43) Veröffentlichungstag der Anmeldung: 06.10.2004
(73) Patentinhaber: Forschungszentrum Jülich GmbH, 52425 Jülich (DE)
(72) Erfinder: VASSEN, Robert, 52134 Horzogenrath (DE); SCHWARTZ-LÜCKGE, Sigrid, 52525 Heinsberg-Randerath (DE); JUNGEN, Wolfgang, 52249 Eschweiler (DE); CAO, Xuegiang, Key Lab of Rare Earth Chem.and Phy., Renmin Str.159, Changchun 130022, Jilin (CN); STÖVER, Detlev, 52382 Niederzier (DE)
(86) Internationale Anmeldenummer: PCT/DE2002/004636
(87) Internationale Veröffentlichungsnummer: WO 2003/057941

(56) Entgegenhaltungen:
- WO-A-99/23271
- WO-A-02/081768
- DE-A- 19 801 424
- VASSEN ET AL.: "Improvement of New Thermal Barrier Coating Systems Using a Layered or Gradient Structure" CERAM. ENG. SCI. PROC. (USA), Bd. 22, Nr. 4, 2001, Seiten 435-442, XP009010501
- PATENT ABSTRACTS OF JAPAN vol. 1998, no. 03, 27. Februar 1998 (1998-02-27) -& JP 09 287065 A (TOSHIBA CORP), 4. November 1997 (1997-11-04)
- PATENT ABSTRACTS OF JAPAN vol. 2003, no. 01, 14. Januar 2003 (2003-01-14) -& JP 2002 275615 A (MITSUBISHI HEAVY IND LTD), 25. September 2002 (2002-09-25)

## Beschreibung

Die Erfindung betrifft einen keramischen Werkstoff für eine Wärmedämmschicht, der insbesondere für den Einsatz bei Temperaturen oberhalb von 1300 °C vorgesehen ist. Des Weiteren betrifft die Erfindung ein Verfahren zur Herstellung eines solchen keramischen Werkstoffes sowie einer diesen Werkstoff enthaltenen Wärmedämmschicht.

### Stand der Technik

Bauteile von Wärmekraftmaschinen, wie beispielsweise Schaufeln von Gasturbinen, unterliegen einer sehr hohen Beanspruchung auf Grund sehr hoher Temperaturen. Diese hohen Temperaturen werden benötigt, um einen hohen Wirkungsgrad zu erzielen, führen aber typischerweise zu einer verstärkten Hochtemperaturkorrosion und zur Oxidation der Bauteile.

Aus der Literatur sind verschiedene Materialien bekannt, die für den Einsatz bei Temperaturen von bis zu 1200 °C geeignet sind. Bei Temperaturen oberhalb von 1200 °C weisen diese Materialien nachteilig jedoch regelmäßig keine lange Lebensdauer auf.

In der Regel werden temperaturbelastete Bauteile durch eine oder mehrere Schichten geschützt.

Ein typisches Schichtsystem besteht beispielsweise aus einer ersten Basisschicht aus MCrAlY, wobei M ein Metall aus der Gruppe Eisen, Nickel, Kobalt oder einer Mischung dieser Metalle ist. Auf diese Basisschicht ist typischerweise eine Aluminiumoxidschicht angeordnet, auf der sich die äußere eigentliche thermische Schutzschicht (Wärmedämmschicht = WDS) befindet. Als Materialien für die Standard Wärmedämmschicht haben sich Yttrium teil- oder vollstabilisiertes Zirkonoxid (YSZ), Cer stabilisiertes Zirkonoxid, Scandium stabilisiertes Zirkonoxid oder mit Seltenerdoxiden stabilisiertes Zirkonoxid herausgestellt. Diese Schichten erlauben eine Oberflächentemperatur der Bauteile von 1200 °C. Höhere Temperaturen führen regelmäßig durch Sintereffekte und/oder Phasenumwandlungen im teilstabilisierten YSZ zu vorzeitigem Versagen der Schichten und damit der Bauteile.

Es sind eine Reihe von Materialien aus der Literatur bekannt, die bei Temperaturen oberhalb von 1200 °C eine erhöhte Phasenstabilität aufweisen. Nachteilig zeigen diese Materialien jedoch bei den hohen Anwendungstemperaturen deutliche Sinterneigung. Dies führt zu einer Verdichtung der WDS und damit zu einer Reduzierung der Thermoschockbeständigkeit, welches ebenfalls nachteilig ein Versagen der WDS bewirkt.

Aus US 4,321,311 A1 ist bekannt, Turbinenschaufeln durch Zwei-Schichtsysteme zu schützen. Die erste Schicht besteht aus einer MCrAlY-Legierung mit M = Metall, beispielsweise Nickel oder Kobalt. Die zweite keramische Schicht besteht beispielsweise aus Zirkonoxid (ZrO₂). Die MCrAlY-Schicht hat die Aufgabe, das Bauteil gegen Heissgaskorrosion zu schützen und gleichzeitig als Haftvermittlerschicht für die eigentliche Wärmeschutzschicht zu wirken.

In "Improvement of new thermal barrier coating systems using a layered or graded structure" von R. Vassen, X. Cao, D. Stoever, Ceramic Engineering and Science Proceedings, 2001 , Band 22(4), Seiten 435-442 werden Gradientenschichten, die YSZ und La₂Zr₂O₇ beinhalten, offenbart. Der Gradient variiert kontinuierlich von reinem YSZ bis La₂Zr₂O₇.

### Aufgabe und Lösung

Eine Aufgabe der Erfindung ist es, ein Verfahren zur Herstellung einer erfindungsgemäßen Wärmedämmschicht mit verringerter Sinterneigung bereitzustellen, die bei Temperaturen oberhalb von 1200 °C beständiger und Thermoschock-resistenter ist, als die Wärmedämmschichten, die bislang aus dem Stand der Technik bekannt sind. Eine weitere Aufgabe der Erfindung ist es, eine Wärmedämmschicht mit den entsprechenden Eigenschaften zu schaffen.

Die erste Aufgabe wird gelöst durch ein Verfahren zur Herstellung einer erfindungsgemäßen Wärmedämmschicht nach Haupt- und erstem Nebenanspruch. Vorteilhafte Ausgestaltungen der Erfindung finden sich in den jeweils darauf rückbezogenen Ansprüchen wieder.
Die zweite Aufgabe wird gelöst durch eine Wärmedämmschicht mit verringerter Sinterneigung mit den Merkmalen des weiteren Nebenanspruchs. Eine vorteilhafte Ausgestaltung der Wärmedämmschicht findet sich in dem darauf zurückbezogenen Anspruch.

### Gegenstand der Erfindung

Das Verfahren zur Herstellung eines Werkstoffes mit verringerter Sinterneigung umfasst den Schritt, dass dem Ausgangsmaterial des Werkstoffes vor dem Sintern eine Fremdphase zugegeben wird. Die Fremdphase weist dabei erfindungsgemäß wenigstens eine Pyrochlorverbindung auf. Geeignete Pyrochlorverbindungen für diese Anwendung sind insbesondere La₂Zr₂O₇, Gd₂Zr₂O₇, Nd₂Zr₂O₇, Sm₂Zr₂O₇, Eu₂Zr₂O₇, La₂Hf₂O₇, oder eine Mischung aus diesen Pyrochloren.

Die zugegebene Fremdphase führt vorteilhaft zu einer Verringerung der Sinteraktivität. Die Fremdphase ist regelmäßig nicht im Matrixgitter des Ausgangsmaterials löslich. Zudem geht die Fremdphase keine Reaktionen mit dem Ausgangsmaterial ein. Der zugegebene Fremdphasenanteil liegt zwischen 0,1 und 50 Vol.-% bezogen auf den gesinterten Werkstoff. Vorteilhafte Bereiche liegen zwischen 10 und 50 Vol.-%.

Es hat sich herausgestellt, dass Pyrochlorverbindungen vorteilhaft als Fremdphasenmaterialien für teil- und vollstabilisiertes Zirkonoxid eingesetzt werden können. Stabilisatoren können dabei unter anderem Y₂O₃, Sc₂O₃ oder auch Ce₂O₃ sein. Bei der Vollstabilisierung des Zirkonoxids, z. B. 8 mol-% Y₂O₃-stabilisiertes ZrO₂, ergibt sich der besondere Vorteil, dass bei Temperaturerhöhung der Werkstoff keine Phasenumwandlung durchläuft, sondern bis zum Schmelzpunkt in kubischer Form vorliegt. Untersuchungen im Rahmen der Entwicklung gradierter und mehrlagiger Systeme aus La₂Zr₂O₇ und YSZ zeigten, dass diese Systeme Temperaturen über 1300 °C für mehr als 100 Stunden ausgesetzt wurden, ohne dass Grenzflächenreaktionen zwischen La₂Zr₂O₇ und YSZ festgestellt werden konnten. Dies bestätigt die hohe Phasenstabilität des Systems La₂Zr₂O₇ / YSZ.

Weitere Ausgangsmaterialien, bei denen sich der Zusatz einer Fremdphase aus Pyrochloren als besonders geeignet für die Verringerung der Sintereigenschaften herausgestellt hat, sind Perowskite, wie beispielsweise SrZrO₃ oder Verbindungen der allgemeinen Form ABO₃, mit A = La, Ce, Pr und Nd und B = Er, Tm, Yb, und Lu, sowie Cerverbindungen, wie beispielsweise CeO₂.

Ferner sind die genannten Pyrochlore als Fremdphase auch für Spinelle oder auch Mullite als Ausgangsmaterialien ebenfalls gut geeignet, um die Sintereingenschaften zu verbessern. Typische Kombinationen sind beispielsweise MgAl₂O₄ (Spinell) mit Zusatz von 30 % La₂Zr₂O₇ oder auch von 30 % Eu₂Hf₂O₇ oder auch Al₆Si₂O₁₃ (Mullite) mit Zusatz von 25 % Nd₂Zr₂O₇ oder Zusatz von 25 % Gd₂Hf₂O₇.

Insbesondere wurde gefunden, dass sich Pyrochlorverbindungen auch vorteilhaft als Fremdphasenzusatz für Defektfluoritverbindungen eignen. Dies gilt in ganz besonderem Maße für die nachfolgend aufgeführten (Defekt-) Fluoritverbindungen aus SE1₂ₓCe₂O₄₊₃ₓ oder SE2₂ₓZr₂O₄₊₃ₓ bzw. SE2₂ₓHf₂O₄₊₃ₓ mit 0 < x ≤ 1. SE1 und SE2 sind Seltenerdelemente, wobei SE2 so zu wählen sind, dass sich bei den angegebenen Konzentrationen die Defektfluoritstruktur einstellt.

Die mit dem erfindungsgemäßen Verfahren herstellbaren Werkstoffe eignen sich insbesondere als Materialien für Wärmedämmschichten. Die verringerte Sinterneigung der Werkstoffe führt regelmäßig bei einer daraus hergestellten und auf einem Bauteil aufgebrachten Wärmedämmschicht zu einer erhöhten Phasenstabilität und einer Verbesserung der Thermoschockstabilität, so dass Anwendungen bei Temperaturen oberhalb von 1200 °C möglich werden.

Im Rahmen der Erfindung sind zwei Verfahren zur Herstellung einer erfindungsgemäßen Wärmedämmschicht denkbar.

In beiden Fällen wird zunächst ein Ausgangsmaterial auf einem Substrat, insbesondere einem Bauteil, abgeschieden. In einer ersten Möglichkeit werden die pulverförmigen Ausgangsmaterialien zunächst in einem Plasma aufgeschmolzen und anschließend abgeschieden. Diesem Ausgangspulver kann je nach Verfahrensvariante ein Teil der Fremdphase als Pulver zugegeben werden. Vorteilhaft weist die Fremdphase eine ähnliche oder feinere Körnung als das Ausgangsmaterial auf, und wird homogen mit diesem vermischt.

Eine zweite Möglichkeit bietet die Abscheidung des Werkstoffs über eine Elektronenstrahlverdampfung (PVD). Dabei diesem Verfahren geht man von sogenannten Ingots aus, die im Elektronenstrahl verdampft werden. Die Ingots selbst werden üblicherweise durch Sinterung des pulverförmigen Ausgangsmaterials hergestellt. Daher kann auch hier je nach Verfahrensvariante eine teilweise Zugabe der Fremdphase als Pulver erfindungsgemäß auch schon in diesem Verfahrensstadium erfolgen.

Die Struktur der auf diese Weise erzeugten Schichten ist sehr unterschiedlich. So ergeben sich bei dem PS-Verfahren Schichten mit lamellenartigen Strukturen mit vielen Rissen und Poren, während sich bei dem PVD-Verfahren stengelkristalline Strukturen ausbilden. Beiden Verfahren gemeinsam ist jedoch, dass sich eine Sinterung regelmäßig nachteilig auf die Beständigkeit bei hohen Temperaturen auswirkt.

Im Rahmen der Erfindung kann die erfindungsgemäße Wärmedämmschicht auch über eine Haftschicht auf dem eigentlichen Bauteil angeordnet werden. Typischerweise wird zwischen einem Substratwerkstoff (Bauteil) und einer keramischen Wärmedämmschicht eine Haftvermittlerschicht angeordnet. Diese bewirkt eine verbesserte Haftung zwischen den Schichten und schützt zudem das Substrat vor Oxidation. Die erfindungsgemäßen Wärmedämmschichten können auf allen gängigen Haftvermittlerschichten aufgebracht werden. Dazu zählen die plasmagespritzten, insbesondere im Vakuum plasmagespritzten (VPS) MCrAlY-Schichten mit M = Ni oder Cr. Für das Aufbringen einer Wärmedämmschicht mittels des PVD-Verfahrens ist eine Glättung der Oberfläche der Haftvermittlerschicht notwendig. Alternativ werden Aluminid- oder Platinaluminid-Schichten als Haftvermittlerschicht eingesetzt. Auch über das PVD-Verfahren hergestellte MCrAlY-Schichten sind möglich.

Da eine über das PS- oder PVD-Verfahren erzeugte Wärmedämmschicht regelmäßig eine offene Porosität aufweist, sieht eine erste Verfahrensvariante der Erfindung vor, bei der Herstellung der Wärmedämmschicht zunächst nur eine Schicht aus dem Ausgangsmaterial auf dem Substrat abzuscheiden. Erst in einem weiteren Schritt wird die abgeschiedene poröse Schicht mit einer Flüssigkeit infiltriert, die die Fremdphase enthält. Dies kann beispielsweise in Form eines Schlickers erfolgen. Als Trägerflüssigkeit sind insbesondere Wasser, Ethanol oder andere leicht flüchtige Alkohole zu nennen. Die Trägerflüssigkeit enthält die Fremdphase in Form eines sehr feinen Pulvers, welches leicht in die Poren der abgeschiedenen Schicht einzudringen vermag. Die Trägerflüssigkeit wird durch leichtes Erwärmen aus der Schicht abgedampft. Die Fremdphase bleibt als fein verteiltes Pulver auf der Oberfläche der Poren der Schicht aus dem Ausgangsmaterial zurück. Bei der sich anschließenden Sinterung, die primär auf Basis von Oberflächendiffusion abläuft, wird so vorteilhaft die Sinterung durch die Fremdphase stark unterdrückt.

In einer weiteren Verfahrensvariante der Erfindung ist es auch denkbar, ein kombiniertes Verfahren anzuwenden. So kann ein erster Teil der Fremdphase mit dem Ausgangsmaterial gemischt und als eine poröse Schicht abgeschieden werden. Anschließend wird ein weiterer Teil der Fremdphase durch Infiltration dieser porösen Schicht zugegeben. Dies kann den vorteilhaften Effekt der Verringerung der Sinterneigung verstärken.

### Spezieller Beschreibungsteil

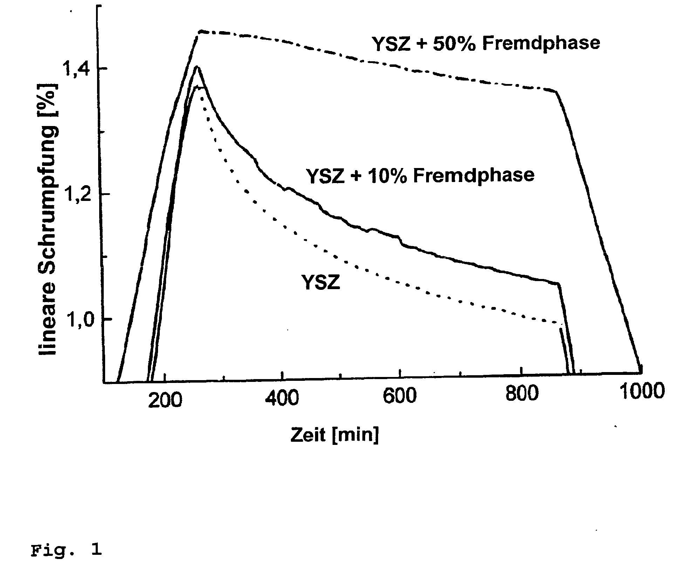

Nachfolgend wird der Gegenstand der Erfindung anhand einer Figur und zweier Ausführungsbeispiele näher erläutert, wobei die Ausführungsbeispiele bereits bekannte Herstellungsverfahren angeben, und die Figur nur zur Verdeutlichung der vorteilhaften Wirkungsweise, die analog auch bei den erfindungemäßen Verfahren, bzw. bei der damit hergestellten Wärmedämmschicht zu beobachten ist, herangezogen werden soll.

Die Figur zeigt die Schrumpfung einer plasmagespritzten YSZ-Schicht im Vergleich zu einer mit La₂Zr₂O₇ dotierten YSZ-Schicht bei 1300 °C. Man erkennt deutlich, dass die Schrumpfung aufgrund der Sinterung durch die Zugabe einer Fremdphase deutlich verringert werden kann. Dieser Effekt wird auch bei einer Wärmedämmschicht, die nach einem der beiden erfindungsgemäßen Verfahren hergestellt wird, erzielt.

### Beispiel 1

Vollstabilisiertes YSZ mit 8 mol-% Y₂O₃ werden mit 10 bis 50 Vol.-% La₂Zr₂O₇ gemischt. Die Durchmischung erfolgt in einem Taumelmischer mit ZrO2-Mahlkugeln in Ethanol für 24 Stunden. Aus dieser Suspension, die einen hohen Feststoffanteil aufweist, wird über Sprühtrocknung ein rieselfähiges Pulver erzeugt. Mit der atmosphärischen Plasmaspritztechnik (APS) wird das Pulver auf einem vorab mit einer VPS-McrAlY-Schicht versehenem Nickelbasis-Superlegierungssubstrat abgeschieden. Die starke Reduzierung des unerwünschten Sinterns in der dotierten Wärmedämmschicht wird in der Figur dargestellt. Während eine WDS aus reinem YSZ innerhalb von 10 Stunden um etwa 0,4 % schrumpft, fällt die Schrumpfung bei der mit 10 Vol.-% La₂Zr₂O₇ dotierten Schicht um etwa 15 % geringer aus.

Deutlich stärker ist der Effekt, bei einer Zugabe an Fremdphase von ca. 50 Vol.-%. Dort wird die Schrumpfung aufgrund der Sinterung auf ein Viertel der einer reinen YSZ-Schicht reduziert.

### Beispiel 2

Einem Ausgangsmaterial aus La₂Ce₂O₇ wird YSZ als Fremdphase zugegeben. Dabei werden schon bei der Herstellung die Pulver entsprechend gemischt. Die homogene, hochkonzentrierte Mischung wird über Sprühtrocknung zu einem rieselfähigen Pulver verarbeitet. Mit der atmosphärischen Plasmaspritztechnik (APS) wurde das Pulver auf einem vorab mit einer VPS-McrAlY-Schicht versehenem Nickelbasis-Superlegierungssubstrat abgeschieden. Es wurden zwei verschiedene Schichten aus La₂(Zr_{0,3}Ce_{0,7})O₇ und La₂(Zr_{0,7}Ce_{0,3})O₇ hergestellt. Bei diesen Verbindungen wurde gegenüber dem reinen Ausgangsmaterial La₂Ce₂O₇ (Defektfluoritstruktur) vorteilhaft eine Reduzierung des Sinterns in plasmagespritzen Schichten um den Faktor 2 bis 10 erreicht.

Alternativ kann eine Wärmedämmschicht aus dieser Werkstoffkombination auch über das EB-PVD-Verfahren hergestellt werden. Dazu wird aus der Pulvermischung aus Ausgangsmaterial und Fremdphase über einen Sinterprozess zunächst ein Ingot hergestellt. Als Substrat dient in diesem Fall eine Nickelbasis-Superlegierung mit einer geglätteten MCrAlY-Schicht mit M = Ni oder Co oder eine über CVD-Verfahren abgeschiedene Platin-Aluminid-Schicht.

### Abkürzung der Verfahren:

- CVD =: (chemical vapor deposition) Chemische Vakuum Abscheidung
- PVD =: (physical vapor deposition) Physikalische Vakuum Abscheidung
- EB-PVD =: (electron-beam physical vapor deposition) Elektronenstrahl-Verdampfung
- PS =: Plasmaspritztechnik
- VPS =: Vakuum Plasmaspritztechnik
- APS =: atmosphärische Plasmaspritztechnik

## Patentansprüche

1. Verfahren zur Herstellung einer Wärmedämmschicht aus einem Ausgangsmaterial und einer in dem Ausgangsmaterial nicht löslichen Fremdphase mit einem Gehalt von 0,1 bis 50 Vol.% auf der Oberfläche eines Substrats, mit den Schritten
a) das Ausgangsmaterial wird zunächst auf einem Substrat in Form einer Schicht mit offener Porosität abgeschieden,
b) die Fremdphase umfassend wenigstens eine Pyrochlorverbindung wird als feines Pulver mit Hilfe einer Flüssigkeit in die poröse abgeschiedene Schicht infiltriert, wobei eine Wärmedämmschicht entsteht, die eine um wenigstens 5 % geringere Sinterneigung gemessen als Linearschrumpfung als das reine Ausgangsmaterial aufweist.

2. Verfahren zur Herstellung einer Wärmedämmschicht aus einem Ausgangsmaterial und einer in dem Ausgangsmaterial nicht löslichen Fremdphase mit einem Gehalt von 0,1 bis 50 Vol.-% auf der Oberfläche eines Substrats, mit den Schritten,
a) die Fremdphase umfassend wenigstens eine Pyrochlorverbindung wird zum Teil zusammen mit dem Ausgangsmaterial auf dem Substrat als poröse Schicht abgeschieden,
und zum Teil als feines Pulver mit Hilfe einer Flüssigkeit in die poröse abgeschiedene Schicht infiltriert, wobei eine Wärmedämmschicht entsteht, die eine um wenigstens 5 % geringere Sinterneigung gemessen als Linearschrumpfung als das reine Ausgangsmaterial aufweist.

3. Verfahren nach einem der Ansprüche 1 bis 2,
bei dem eine Pyrochlorverbindung aus der Gruppe, umfassend (La₂Zr₂O₇, Gd₂Zr₂O₇, Nd₂Zr₂O₇, Sm₂Zr₂O₇, Eu₂Zr₂O₇, La₂Hf₂O₇ oder eine Mischung davon) als Fremdphase eingesetzt wird.

4. Verfahren nach einem der Ansprüche 1 bis 3,
bei dem ein voll- oder teilstabilisiertes Zirkoniumoxid als Ausgangsmaterial eingesetzt wird.

5. Verfahren nach einem der Ansprüche 1 bis 3,
bei dem ein Spinell, ein Mullit oder eine Cerverbindung Ausgangsmaterial eingesetzt wird.

6. Verfahren nach einem der Ansprüche 1 bis 3,
bei dem eine Perowskitverbindung umfassend SrZrO₃ oder eine Verbindung der allgemeinen Formel ABO₃, mit A = La, Ce, Pr oder Nd und B = Er, Tm, Yb oder Lu als Ausgangsmaterial eingesetzt wird.

7. Verfahren nach einem der Ansprüche 1 bis 3,
bei dem eine (Defekt-)Fluoritverbindung aus der Gruppe, umfassend SE1₂ₓCe₂O₄₊₃ₓ oder SE2₂ₓZr₂O₄₊₃ₓ bzw. SE2₂ₓHf₂O₄₊₃ₓ mit 0 < x ≤ 1 und SE1 und SE2 = Seltenerdelemente als Ausgangsphase eingesetzt wird.

8. Verfahren nach einem der Ansprüche 1 bis 7, bei dem zunächst eine zusätzliche Haftvermittlerschicht zwischen Substrat und Wärmedämmschicht abgeschieden wird.

9. Wärmedämmschicht für Anwendungen oberhalb von 1200 °C auf der Oberfläche eines Substrats, **dadurch gekennzeichnet,**
- **dass** die Wärmedämmschicht ein Ausgangsmaterial in Form einer porösen Matrix aus
a) einem voll oder teilstabilisierten Zirkonoxid oder
b) einem Mullit, einem Spinell oder einer Cerverbindung oder
c) einer Perowskitverbindung der allgemeinen Formel ABO₃, mit A = La, Ce, Pr oder
Nd und B = Er, Tm, Yb oder Lu oder
d) einer (Defekt-)Fluoritverbindung aus der Gruppe, umfassend SE1₂ₓCe₂O₄₊₃ₓ oder
SE2₂ₓZr₂O₄₊₃ₓ bzw. SE2₂ₓHf₂O₄₊₃ₓ, mit 0 < x ≤ 1 und SE1 und SE2 = Seltenerdenelemente, und
- **dass** die Wännedämmschicht in den Poren eine in dem Matrixmaterial des Ausgangsmaterials nicht lösliche Pyrochlorverbindung umfassend La₂Zr₂O₇, La₂Hf₂O₇, Gd₂Zr₂O₇, Nd₂Zr₂O₇, Sm₂Zr₂O₇, Eu₂Zr₂O₇ oder eine Mischung daraus als Fremdphase aufweist,
wobei die Fremdphase mit einem Gehalt von 0,1 bis 50 Vol.-% in der Wärmedämm-schicht verteilt vorliegt, und wobei die Wärmedämmschicht beim Sintern eine um wenigstens 5 % geringere Sinterneigung gemessen als Linearschrumpfung als das reine Ausgangsmaterial aufweist.

10. Wärmedämmschicht nach Anspruch 10, mit einer zusätzlich angeordneten Haftvermittlerschicht zwischen der Wärmedämmschicht und der Oberfläche des Substrats.

## Claims

1. Method for producing a heat-insulating layer from a starting material and a foreign phase, which may not be dissolved in the starting material, with a content of 0.1 to 50% by volume on the surface of a substrate, with the steps
a) first the starting material will be precipitated on a substrate in the form of a layer with open porosity,
b) the foreign phase comprising at least one pyrochlore compound will be infiltrated into the porous layer precipitated as a fine powder with the help of a liquid, in which a heat-insulating layer is produced, which has at least a 5% smaller tendency towards sintering, which is measured as a linear contraction, than the pure starting material.

2. Method for producing a heat-insulating layer from a starting material and a foreign phase, which may not be dissolved in the starting material, with a content of 0.1 to 50% by volume on the surface of a substrate, with the steps,
a) the foreign phase comprising at least one pyrochlore compound will be precipitated partly together with the starting material on the substrate as a porous layer,
and partly infiltrated into the porous layer precipitated as a fine powder with the help of a liquid, in which a heat-insulating layer is produced,
which has at least a 5% smaller tendency towards sintering, which is measured as a linear contraction, than the pure starting material.

3. Method according to one of claims 1 to 2,
in which a pyrochlore compound from the group comprising (La₂Zr₂O₇, Gd₂Zr₂O₇, Nd₂Zr₂O₇, Sm₂Zr₂O₇, Eu₂Zr₂O₇, La₂Hf₂O₇ or a mixture of these) is used as the foreign phase.

4. Method according to one of claims 1 to 3,
in which a completely or partly stabilised zirconium oxide is used as the starting material.

5. Method according to one of claims 1 to 3,
in which a spinel, mullite or cerium compound is used as the starting material.

6. Method according to one of claims 1 to 3,
in which a perowskite compound comprising SrZrO₃ or a compound of the general formula ABO₃ with A = La, Ce, Pr or Nd and B = Er, Tm,
Yb or Lu is used as the starting material.

7. Method according to claims 1 to 3,
in which a (defect) fluorite compound from the group comprising SE1_{2X}Ce₂O_{4+3X} or SE_{2X}Zr₂O_{4+3X} or SE2_{2X}Hf₂O_{4+3X} with 0 < x ≤ 1 and SE1 and SE2 = rare earth elements is used as the starting phase.

8. Method according to one of claims 1 to 7, in which first an additional layer of coupling agent is precipitated between the substrate and the heat-insulating layer.

9. Heat-insulating layer for uses above 1200° C on the surface of a substrate, **characterised in that**,
- the heat-insulating layer has a starting material in the form of a porous matrix made of
a) a completely or partly stabilised zirconium oxide or
b) a mullite, spinel or cerium compound or
c) a perovskite compound of the general formula ABO₃ with A = La, Ce, Pr or
Nd and B = Er, Tm, Yb or Lu or
d) a (defect) fluorite compound from the group comprising SEI_{2X}Ce₂O_{4+3X} or
SE2_{2X}Zr₂O_{4+3X} or SE2_{2X}Hf₂O_{4+3X} with 0 < x < 1 and SE1 and SE2 = rare earth elements, and
- the heat-insulating layer in the pores has a pyrochlore compound, which may not be dissolved in the matrix material of the starting material, comprising La₂Zr₂O₇, La₂Hf₂O₇, Gd₂Zr₂O₇, Nd₂Zr₂O₇, Sm₂Zr₂O₇, Eu₂Zr₂O₇ or a mixture of these as the foreign phase,
in which the foreign phase is present distributed in the heat-insulating layer with a content of 0.1 to 50% by volume and in which, when sintered, the heat-insulating layer has at least a 5% smaller tendency towards sintering, which is measured as a linear contraction, than the pure starting material.

10. Heat-insulating layer according to claim 10 with an additional layer of coupling agent arranged between the heat-insulating layer and the surface of the substrate.

## Revendications

1. Procédé de production d'une couche calorifuge constituée d'un matériau de départ et d'une phase étrangère non soluble dans le matériau de départ présentant une teneur de 0,1 à 50 % en volume sur la surface d'un substrat, comportant les étapes suivantes :
a) le matériau de départ est tout d'abord déposé sur un substrat sous la forme d'une couche présentant des pores ouverts,
b) la phase étrangère comprenant au moins un composé pyrochloro est infiltrée sous forme de poudre fine à l'aide d'un liquide dans la couche poreuse déposée, une couche calorifuge se formant, qui présente une tendance au frittage inférieure de 5 % mesurée en tant que rétrécissement linéaire par rapport au matériau de départ pur.

2. Procédé de production d'une couche calorifuge constituée d'un matériau de départ et d'une phase étrangère non soluble dans le matériau de départ, présentant une teneur de 0,1 à 50 % en volume sur la surface d'un substrat, comportant les étapes suivantes
a) la phase étrangère comprenant au moins un composé pyrochloro est déposée en partie conjointement avec le matériau de départ sur le substrat sous forme de couche poreuse,
et en partie infiltrée sous forme de poudre fine à l'aide d'un liquide dans la couche poreuse déposée, une couche calorifuge se formant, qui présente une tendance au frittage inférieure de 5 % mesurée en tant que rétrécissement linéaire par rapport au matériau de départ pur.

3. Procédé selon l'une des revendications 1 à 2,
dans lequel un composé pyrochloro du groupe comprenant (La₂Zr₂O₇, Gd₂Zr₂O₇, Nd₂Zr₂O₇, Sm₂Zr₂O₇, Eu₂Zr₂O₇, La₂Hf₂O₇ ou un mélange de ceux-ci) est utilisé comme phase étrangère.

4. Procédé selon l'une des revendications 1 à 3,
dans lequel un oxyde de zirconium entièrement ou partiellement stabilisé est utilisé comme matériau de départ.

5. Procédé selon l'une des revendications 1 à 3,
dans lequel on utilise une spinelle, une mullite ou un composé de cérium comme matériau de départ.

6. Procédé selon l'une des revendications 1 à 3,
dans lequel on utilise un composé de pérovskite comprenant du SrZrO₃ ou un composé de formule générale ABO₃, où A = La, Ce, Pr ou Nd et B = Er, Tm, Yb ou Lu comme matériau de départ.

7. Procédé selon l'une des revendications 1 à 3,
dans lequel on utilise un composé de fluorite (défecteux) du groupe comprenant SE1₂ₓCe₂O₄₊₃ₓ ou SE2₂ₓZr₂O₄₊₃ₓ ou SE2₂ₓHf₂O₄₊₃ₓ où 0 < x ≤ 1 et SE1 et SE2 = éléments de terres rares comme phase de départ.

8. Procédé selon l'une des revendications 1 à 7, dans lequel une couche adhésive supplémentaire est tout d'abord déposée entre le substrat et la couche calorifuge.

9. Couche calorifuge pour des utilisations à plus de 1200° C sur la surface d'un substrat, **caractérisée en ce que**
- la couche calorifuge présente un matériau de départ sous la forme d'une matrice poreuse de
a) un oxyde de zirconium complètement ou partiellement stabilisé ou
b) une mullite, une spinelle ou un composé de cérium ou
c) un composé de pérovskite de formule générale ABO₃, où A = La, Ce, Pr ou
Nd et B = Er, Tm, Yb ou Lu ou
d) un composé de fluorite (défectueux) du groupe comprenant
SE1₂ₓCe₂O₄₊₃ₓ ou
SE2₂ₓZr₂O₄₊₃ₓ ou SE2₂ₓHf₂O₄₊₃ₓ où 0 < x ≤ 1 et SE1 et SE2 = éléments de terres rares et
**en ce que** la couche calorifuge présente dans les pores un composé pyrochloro non soluble dans le matériau de matrice du matériau de départ comprenant (La₂Zr₂O₇, La₂Hf₂O₇, Gd₂Zr₂O₇, Nd₂Zr₂O₇, Sm₂Zr₂O₇, Eu₂Zr₂O₇, ou un mélange de ceux-ci comme phase étrangère,
la phase étrangère étant répartie avec une teneur de 0,1 à 50 % en volume dans la couche calorifuge et la couche calorifuge présentant lors du frittage une tendance de frittage inférieure à 5 % mesurée en tant que rétrécissement linéaire par rapport au matériau de départ pur.

10. Couche calorifuge selon la revendication 10, présentant une couche adhésive disposée de façon supplémentaire entre la couche calorifuge et la surface du substrat.
